# EUROPEAN PATENT APPLICATION

(11) **EP 4 362 092 A1**
(43) Date of publication of application: **01.05.2024**
(21) Application number: 23203710.1
(22) Date of filing: 16.10.2023
(51) Int. Cl.: H01L 25/07

(54) **MONOLITHIC MULTIPLE-CHANNEL PROTECTION DEVICE**

(30) Priority: 14.10.2022 CN 202211261099
(71) Applicant: Littelfuse Semiconductor (Wuxi) Co., Ltd., Wuxi, Jiangsu 214142 (CN)
(72) Inventor: Zhang, Glenda, Wuxi, 214142 (CN); Shi, Lei, Wuxi, 214142 (CN); Gao, Chao, Wuxi, 214142 (CN)
(74) Representative: Arnold & Siedsma

(57) **Abstract**

A multiple-channel protection device and associated methods thereof. The device includes a first lead having a first chip attachment portion and a second chip attachment portion, a second lead having a third chip attachment portion, and a third lead having a fourth chip attachment portion. A first semiconductor chip is configured to be conductively coupled to the first chip attachment portion and the third chip attachment portion. A second semiconductor chip is configured to be conductively coupled to the second chip attachment portion and the fourth chip attachment portion.

## Description

### TECHNICAL FIELD

This disclosure relates generally to the field of semiconductor devices, and in particular, to monolithic multiple-channel (e.g., two-channel) protection devices.

### BACKGROUND

Transient voltage suppression (TVS) diodes are electronic components designed to protect sensitive electronics from high voltage transients. TVS diodes can respond to overvoltage events faster than most other types of circuit protection devices and are available in a variety of surface mount and through-hole circuit board mounting formats. TVS diodes are generally used to protect against electrical overstress such as those induced by lightning strikes, inductive load switching, and electrostatic discharge (ESD) associated with transmission on data lines and electronic circuits. Existing semiconductor technologies are not capable of providing multi-channel protection device for electronic circuit components in an effective manner.

### SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

In some implementations, the current subject matter relates to a multiple-channel protection device/apparatus. The device may include a first lead having a first chip attachment portion and a second chip attachment portion, a second lead having a third chip attachment portion, and a third lead having a fourth chip attachment portion. A first semiconductor chip may be configured to be conductively coupled to the first chip attachment portion and the third chip attachment portion. A second semiconductor chip may be configured to be conductively coupled to the second chip attachment portion and the fourth chip attachment portion.

In some implementations, the current subject matter may include one or more of the following optional features. The apparatus may include a first substrate layer positioned over the third chip attachment portion and the first semiconductor chip. It may also include a second substrate layer sandwiched between the first chip attachment portion and the second chip attachment portion. A third substrate layer may be positioned over the fourth chip attachment portion and the second semiconductor chip.

In some implementations, the second lead may be conductively separate from the third lead.

In some implementations, the apparatus may include a first conductive channel conductively coupling the first lead, the first chip attachment portion, the first semiconductor chip, the third chip attachment portion, and the second lead. It may also include a second conductive channel conductively coupling the first lead, the second chip attachment portion, the second semiconductor chip, the fourth chip attachment portion, and the third lead.

In some implementations, at least one of the first lead, the first chip attachment portion, the second chip attachment portion, the second lead, the third chip attachment portion, the third lead, and the fourth chip attachment portion may include at least one of the following: zinc, copper, silver, aluminum, metals, alloys thereof, and/or any combinations thereof.

In some implementations, at least one of the first and second semiconductor chips may include one or more respective working areas. At least one of the first, second, third, and fourth chip attachment portions may be configured to be conductively coupled to the one or more respective working areas of corresponding first and second semiconductor chips.

In some implementations, at least one of the first, second and third leads may be configured to be coupled to at least one of the following: a substrate, a printed circuit board, and any combination thereof.

In some implementations, a first fill layer may be configured to be formed for encapsulating the first semiconductor chip, the first chip attachment portion and the third chip attachment portion. A second fill layer may be configured to be formed for encapsulating the second semiconductor chip, the second chip attachment portion and the fourth chip attachment portion. At least one of the first and second fill layers may be manufactured from at least one of the following: an epoxy compound, a plastic, and any combination thereof.

In some implementations, the device may be configured to be a surface mounted apparatus. In some implementations, at least one of the first and second semiconductor chips may include at least one transient voltage suppression device.

In some implementations, the current subject matter relates to a method for assembly and/or manufacture of the above multiple channel protection device. The method may include providing one or more substrate layers, the one or more substrate layers being coupled to one or more chip connection portions; providing one or more semiconductor chips; coupling at least one of the one or more semiconductor chips to at least one of the one or more chip connection portions; forming one or more fill layers to encapsulate the coupled at least one of the one or more semiconductor chips and at least one of the one or more chip connection portions; applying one or more coating layers to at least one of the one or more formed fill layers; and forming one or more leads in the encapsulated at least one of the one or more semiconductor chips and at least one of the one or more chip connection portions, the one or more leads being connected to at least one of the one or more chip connection portions..

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the disclosed implementations. In the drawings,
FIGS. 1a-c illustrate an exemplary two-channel protection device, according to some implementations of the current subject matter;
FIGS. 2a-c illustrate further details of the interior structure of the device of the device shown in FIGS. 1a-c;
FIGS. 3a-c illustrate further details of the interior structure of the device shown in FIGS. 1a-c; and
FIG. 4 illustrates an exemplary process, according to some implementations of the current subject matter.

The drawings are not necessarily to scale. The drawings are merely representations, not intended to portray specific parameters of the disclosure. The drawings are intended to depict exemplary implementations of the current subject matter, and therefore, are not to be considered as limiting in scope. In the drawings, like numbering represents like elements.

Further, certain elements in some of the figures may be omitted, and/or illustrated not-to-scale, for illustrative clarity. Cross-sectional views may be in the form of "slices", and/or "near-sighted" cross-sectional views, omitting certain background lines otherwise visible in a "true" cross-sectional view, for illustrative clarity. Additionally, for clarity, some reference numbers may be omitted in certain drawings.

### DETAILED DESCRIPTION

Various approaches in accordance with the present disclosure will now be described more fully hereinafter with reference to the accompanying drawings, where implementations of a system and method are shown. The devices, system(s), component(s), etc., may be embodied in many different forms and are not to be construed as being limited to the example implementations set forth herein. Instead, these example implementations are provided so this disclosure will be thorough and complete, and will fully convey the scope of the current subject matter to those skilled in the art.

To address these and potentially other deficiencies of currently available solutions, one or more implementations of the current subject matter relate to methods, systems, articles of manufacture, and the like that can, among other possible advantages, provide a monolithic multiple-channel (e.g., two-channel) protection device. Such exemplary multiple-channel protection device may be configured to include a structure incorporating one or more connection pins and/or leads (e.g., one pin/lead on one side of the structure and two pins/leads on an opposite side of the structure) disposed within respective pin housings. The pins/leads may be internally configured to be coupled, via one or more conductive connectors (e.g., copper, copper alloy, metal, metal alloy, etc. ), to one or more semiconductor devices (e.g., semiconductor chips, TVS devices, diodes, etc.) positioned in an interior of the structure. The interior may be filled using an underfill non-conductive material (which can be any desired material, such as epoxy, etc.). The interior may be further enclosed by one or more substrate(s) and/or printed circuit board(s) that may be secured to pin housings. The discussion herewith is presented with regard to a two-channel protection device, however, as can be understood, any number of channels may be used.

Transient voltage suppressor (TVS) semiconductor devices may be used to protect electronic components from transient voltages, overvoltage, etc. A TVS chip typically serves as a core part for a TVS semiconductor device. As can be understood, any other types of semiconductor chips and/or devices may be used. As stated above, such TVS devices may be used to protect against voltage transients that may be detrimental to operation of various electronic components.

Voltage transients are defined as short duration surges of electrical energy and are the result of the sudden release of energy previously stored and/or induced by other means, such as, for example, heavy inductive loads, lightning, etc. Voltage transients may be classified into predictable or repeatable transients and random transients. In electrical or electronic circuits, this energy can be released in a predictable manner via controlled switching actions, or randomly induced into a circuit from external sources. Repeatable transients are frequently caused by the operation of motors, generators, and/or the switching of reactive circuit components. On the other hand, random transients are often caused by electrostatic discharge (ESD) and lightning, which generally occur unpredictably.

ESD is characterized by very fast rise times and very high peak voltages and currents, which may be the result of an imbalance of positive and negative charges between objects. ESD that is generated by everyday activities can surpass a vulnerability threshold of standard semiconductor technologies. In case of lightning, even though a direct strike is destructive, voltage transients induced by lightning are not the result of a direct strike. When a lightning strike occurs, the event can generate a magnetic field, which, in turn, can induce voltage transients of large magnitude in nearby electrical cables. For example, a cloud-to-cloud strike will affect not only overhead cables, but also buried cables. Even a strike 1 mile distant (1.6km) can generate 50 volts in electrical cables. In a cloud-to-ground strike, the voltage transient generating effect is significantly greater.

In some cases, TVS chips may be packaged using surface mounting packaging, which provides for high power while having an overall small size. For example, SMC packaging may be used in printed circuit boards (PCBs) to protect various electronic components from ESD, electrical fast transients (EFT), lightning, and/or any other transients. SMC packaging allows for surface mounting of electronic components as well as optimization of the space on the PCB (on which such components may be mounted). It may further be characterized by a small profile, improved clamping capability, as well as other enhanced features.

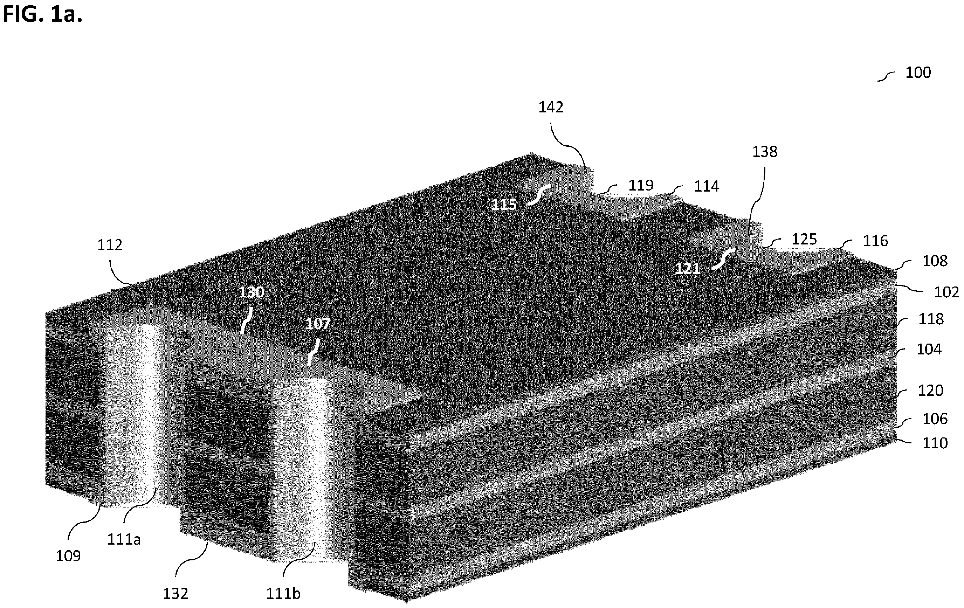

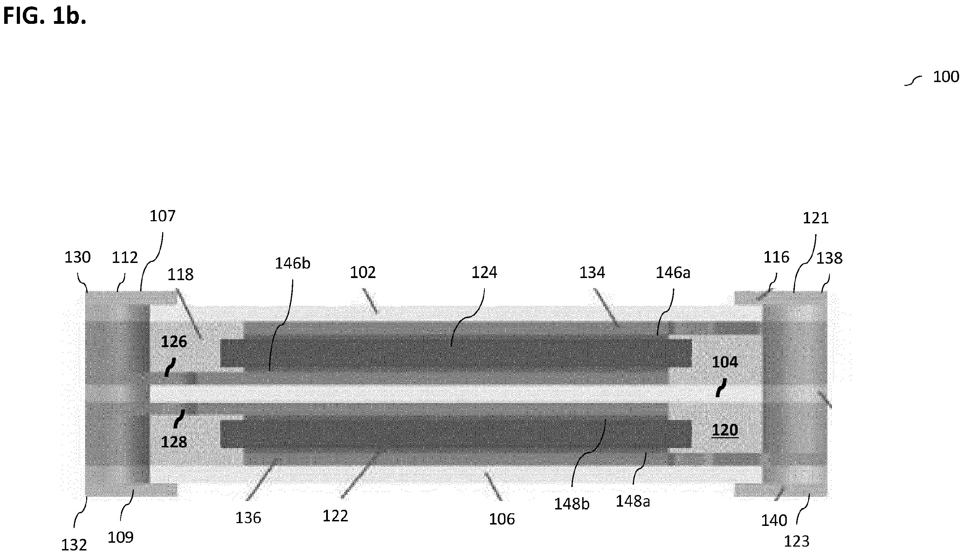

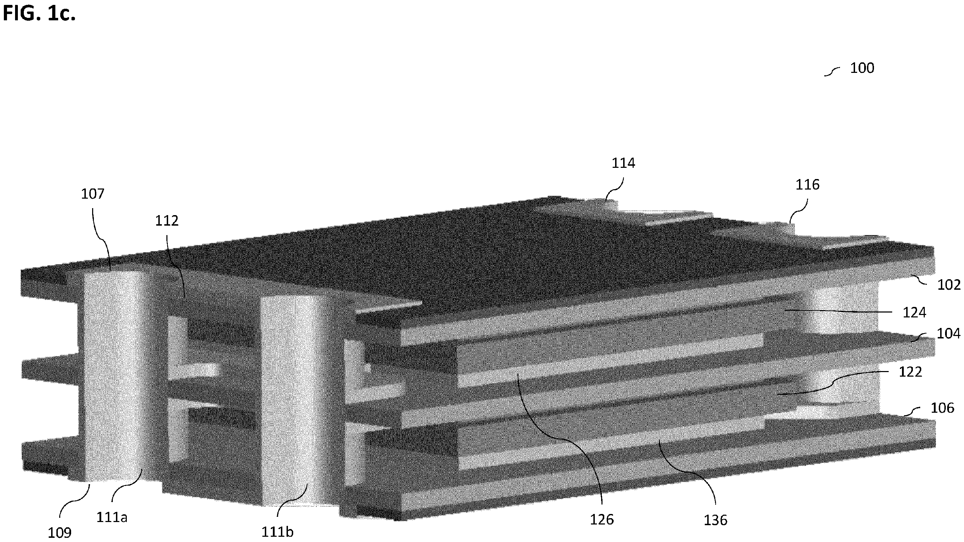

FIGS. 1a-c illustrate an exemplary two-channel protection device 100, according to some implementations of the current subject matter. FIG. 1a is a perspective view of the device 100. FIG. 1b is a side transparent view of the device 100. FIG. 1c is a perspective view of the device 100 without fill material layers.

Referring to FIGS. 1a-c, the device 100 may be configured to include a first and/or top substrate and/or printed circuit board (PCB) layer 102, a second and/or middle substrate/PCB layer 104, a third and/or bottom substrate/PCB layer 106, a first and/or top solder resist layer 108, a second and/or bottom solder resist layer 110, a first pin or lead (terms that will be used interchangeably herewith) housing 112, a second pin housing 114, a third pin housing 116, a top and/or first fill material layer 118, and a bottom and/or second fill material layer 120.

The resist layer 108 may be configured to be applied to a top surface of the layer 102, which corresponds to the surface that faces away from an interior of the device 100. The resist layer 110 may be configured to be applied to a bottom surface of the layer 106, which corresponds to the surface that faces away from the interior of the device 100.

The fill material 118 may be configured to be positioned and/or sandwiched between the layer 102 and the layer 104. The material 118 may be configured to encapsulate interior components of the structure 100, such as, for example, a first semiconductor chip (not shown in FIG. 1a), a pin connection extending from the pin housing 112 (not shown in FIG. 1a), and a pin connection extending from the pin housing 114 (not shown in FIG. 1a). The material layer 118 may be configured to be manufactured from an epoxy, plastic, and/or any other suitable non-conductive material.

The fill material layer 120 may be configured to be positioned and/or sandwiched between the layer 104 and the layer 106. The material layer 120 may be configured to encapsulate interior components of the structure 100, such as, for example, a second semiconductor chip (not shown in FIG. 1a), another pin connection extending from the pin housing 112 (not shown in FIG. 1a), and a pin connection extending from the pin housing 116 (not shown in FIG. 1a). The material layer 120 may likewise be configured to be manufactured from an epoxy, plastic, and/or any other suitable non-conductive material.

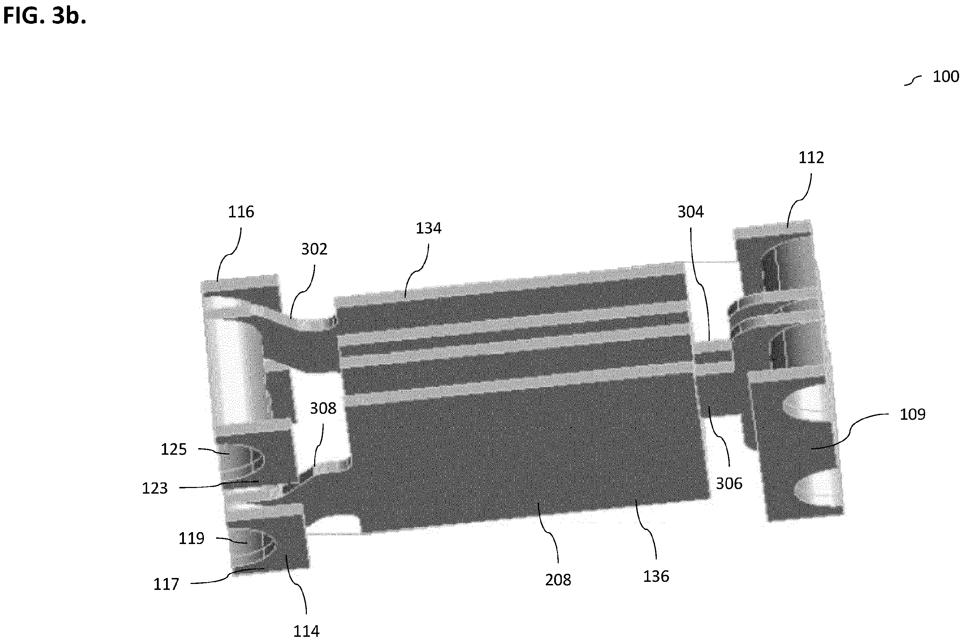

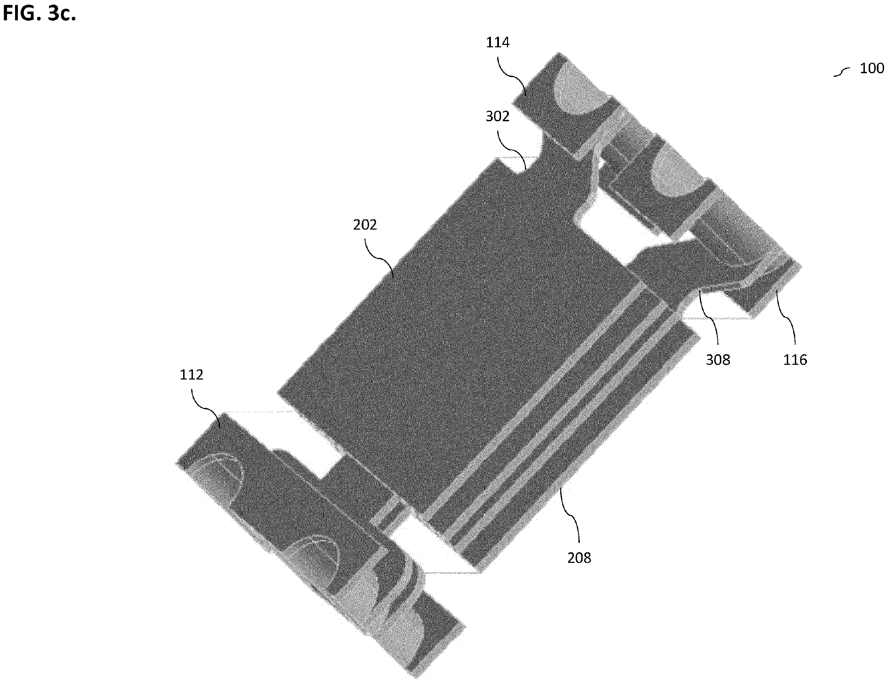

The pin housing 112 may include a top portion 107 and a bottom portion 109 as well as semi-/cylindrical grooves and/or openings 111(a, b) disposed between the top and bottom portions 107, 109. The pin housing 112 may also be coupled to pin connections 126, 128 (and/or formed as a single unit with openings 111 being formed by drilling). The pin housing 114 may include a top portion 115 and a bottom portion 117 as well as a semi-/cylindrical groove and/or opening 119 disposed between the top and bottom portions 115, 117 (as shown in FIGS. 1a-b and 3b). The pin housing 114 may also be coupled to pin connection 134 (and/or formed as a single unit with opening 119 being formed by drilling). The pin housing 116 may include a top portion 121 and a bottom portion 123 as well as a semi-/cylindrical groove and/or opening 125 disposed between the top and bottom portions 121, 123 (as shown in FIGS. 1a-b and 3b). The pin housing 116 may also be coupled to pin connection 136 (and/or formed as a single unit with opening 125 being formed by drilling).

The layers 102-110 and 118-120 (as well as the semiconductor chips (not show in FIGS. 1a-c)) may be configured to be disposed substantially parallel to one another.

As shown in FIG. 1a, the housings 112-116 may have semi-/cylindrical grooves/openings 111, 119, 125, respectively. However, as can be understood, the grooves/openings 111, 119, 125may have any desired shape, form, dimension, etc. As stated above, the pin housing 112 (e.g., including its pin connection portions 126, 128) may be a unitary housing and may be configured to provide a single external electrical connection to the semiconductor chips disposed in the interior of the device 100. The pin housings 114 and 116 may be separate pin housings (each pin housing may also be unitary housings that include their respective pin connections 134, 136), where each housing 114 and 116 may be configured to be individually coupled to the respective semiconductor chips disposed inside the device 100. For example, the housing 114 may be configured to be conductively coupled to the semiconductor chip positioned within the layer 118, whereas the housing 116 may be configured to be conductively coupled to the semiconductor chip positioned within the layer 120, as will be discussed in further detail below.

Referring to FIG. 1b, in addition to the layering structure shown in FIG. 1a, the device 100 may be configured to include two semiconductor devices or chips 122 and 124. As can be understood, the device 100 may be configured to include more than one semiconductor chip. Moreover, multiple semiconductor chips may be configured to be positioned in a stackable fashion similar to what is shown in FIGS. 1a-b. The chips can be TVS devices and/or any other type of semiconductor device. As shown in FIG. 1b, semiconductor chip 122 may be configured to be positioned in a bottom portion of the device 100 and, in particular, may be disposed within the bottom layer 120. The semiconductor chip 124 may be configured to be positioned in a top portion of the device 100 and, in particular, may be disposed within the top layer 118.

Each semiconductor chip 122, 124 may be conductively coupled (e.g., using solder and/or any other methods) to pin housings 112, 114, and 116 using respective pin connections. For example, the semiconductor chip 122 may be conductively coupled to a pin connection 128 of the pin housing 112. The chip 122 may also be conductively coupled to a pin connection 136 of the pin housing 116. The chip 122 is not coupled (within the device 100) to the pin housing 114. The connection between the chip 122 and the pin connection 136 may be accomplished using a solder layer 148a, whereas the connection between the chip 122 and the pin connection 128 using a solder layer 148b. As such, the semiconductor chip 122 may be conductively coupled to two pin housings 112, 116 which, in turn, may be coupled to other electrical components (not shown in FIGS. 1a-b).

Electrical connection of the pin housing 112 to other external components may be accomplished using conductive ends 130 and 132. Alternatively, or in addition to, the conductive ends 130, 132 may be in a form of a single conductive end. In either case, the conductive end(s) may be conductively coupled to other electrical components (not shown in FIGS. 1a-b), e.g., using soldering, clamping, welding, etc. The pin housing 116 may include conductive ends 138 and 140, which may be used for connection to other external electrical components (not shown in FIGS. 1a-b). The pin housing 114 may include conductive ends 142 and 144, which may be used for connection to other external electrical components (not shown in FIGS. 1a-b).

Similarly, the semiconductor chip 124 may be conductively coupled to a pin connection 126 of the pin housing 112. The chip 124 may also be conductively coupled to a pin connection 134 of the pin housing 114 (not shown in FIG. 1b). The chip 124 is not coupled (within the device 100) to the pin housing 116. The connection between the chip 124 and the pin connection 134 may be accomplished using a solder layer 146a, whereas the connection between the chip 124 and the pin connection 126 using a solder layer 146b. Hence, the semiconductor chip 124 may be conductively coupled to two pin housings 112, 114, which, in turn, may be coupled to other electrical components (not shown in FIGS. 1a-b).

As shown in FIG. 1c, the semiconductor chips 122, 124 may be positioned between and conductively coupled to the respective pin connections 126, 128 (not shown in FIG. 1c), 134 (not shown in FIG. 1c), and 136. Moreover, the semiconductor chips 122, 124 may be positioned or sandwiched substantially in the middle between respective layers 102, 104, and 106. Such positioning creates a stackable structure that separates "top" and "bottom" leads and may be advantageous in providing an enhanced two-channel impulse surge protection.

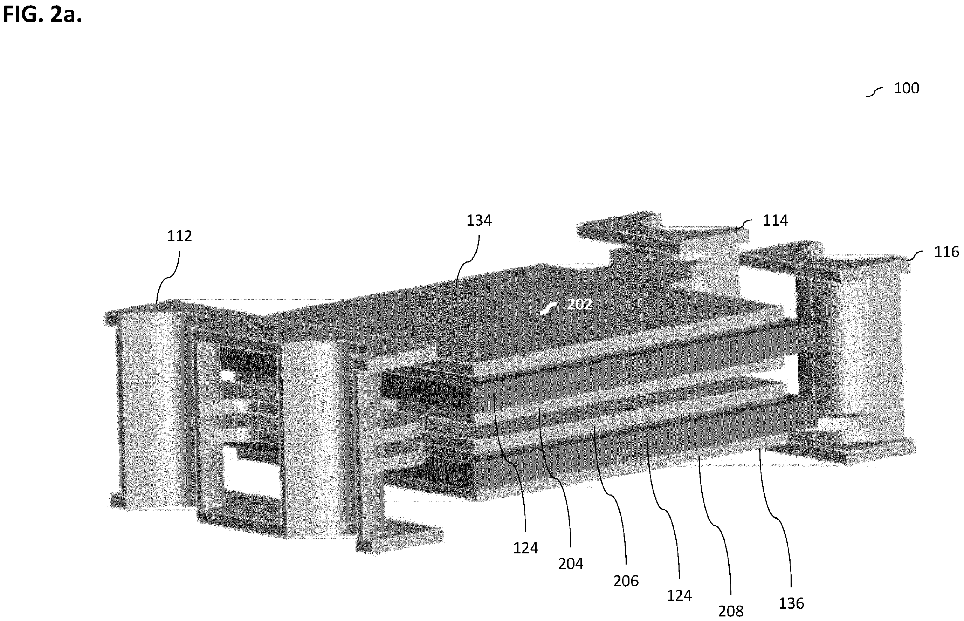

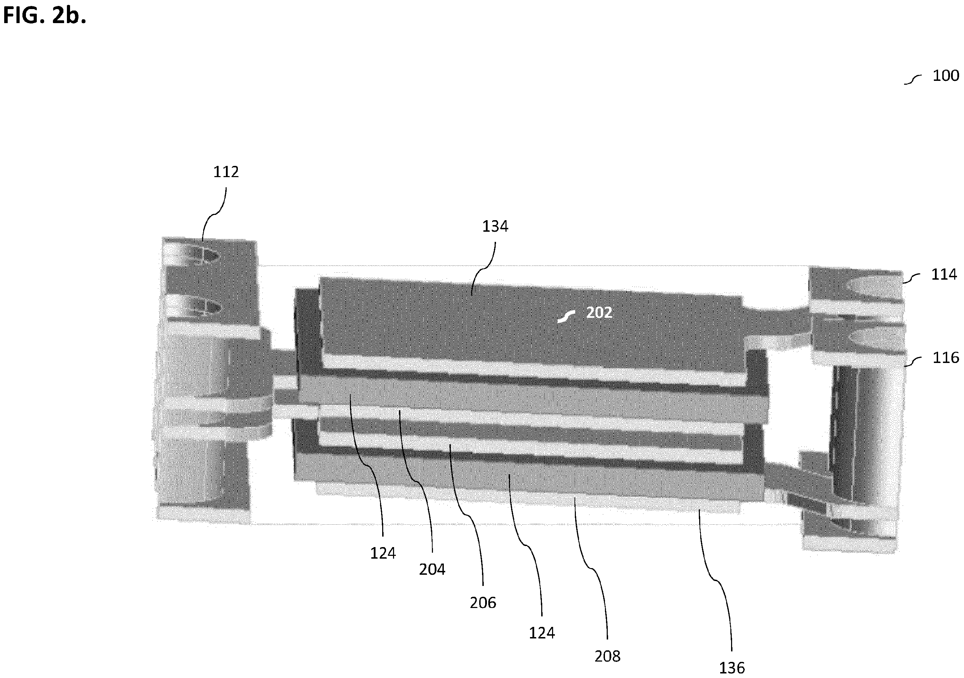

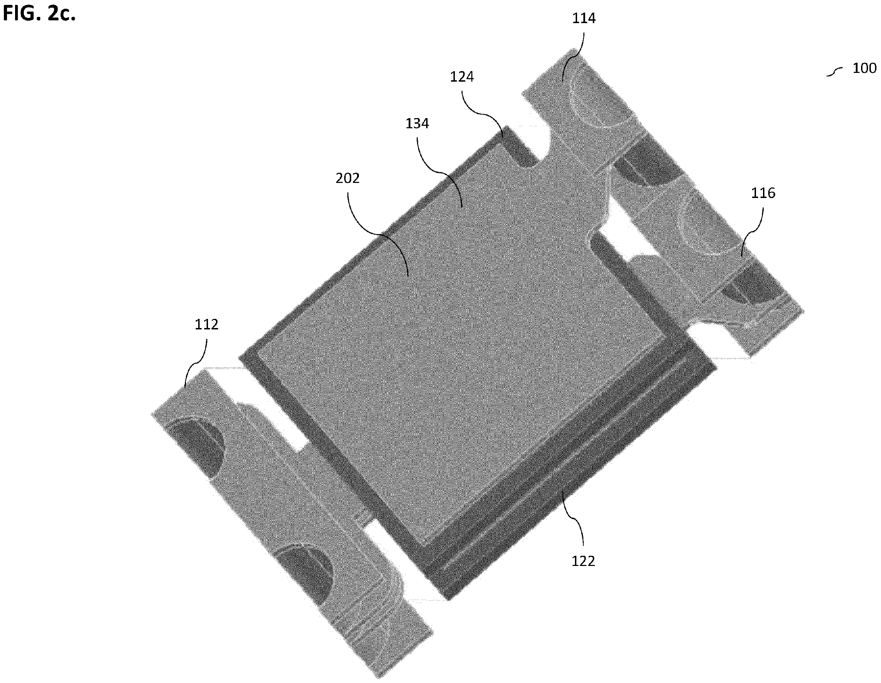

FIGS. 2a-c illustrate further details of the interior structure of the device 100 shown in FIGS. 1a-c. In particular, FIGS. 2a-c illustrate the device 100 with the layers 102-110 and layers 118-120 removed. FIGS. 2a-b are perspective side views of the device 100 and FIG. 1c is a top view of the device 100.

As shown in FIGS. 2a-c, the pin housing 112 may be configured to include two conductive pin connections 126 and 128. The pin connections 126, 128 may be configured to be conductively coupled to a middle portion of the pin housing 112. As can be understood, the pin connections 126, 128 may be coupled to the pin housing 112 in any desired location. Alternatively, or in addition, the pin connections 126, 128 and the pin housing 112 may be configured to form a unitary structure (e.g., without a need for creating separate connections between the pin connections 126, 128 and the pin housing 112).

In some implementations, the pin connections 126, 128 may be configured to include chip connection portions that may be appropriately sized for coupling to the respective chips 122, 124. For example, the pin connection 126 may be configured to have a chip connection portion 204 that may be used for conductively coupling to a bottom surface of the chip 124. The pin connection 128 may likewise have a chip connection portion 206 for conductively coupling to a top surface of the chip 122. The chip connection portions 204 and 206 may be separated by the layer 104 (as shown in FIGS. la-c). As stated above, the conductive coupling between the respective chip connection portions 204, 206 and the chips 122, 124 may be accomplished using soldering and/or any other desired methods.

The chip connection portions 204, 206 may be configured to have surface areas that may be smaller than the surface areas (to which they are coupled) of the respective semiconductor chips 122, 124. In some exemplary implementations, the chip connection portions 204, 206 may be configured to be conductively coupled to respective working areas of the chips 122, 124.

The pin housing 114 may be configured to include a single conductive pin connection 134. The pin connection 134 may be configured to be conductively coupled to a top portion of the pin housing 114. As can be understood, the pin connection 134 may be coupled to the pin housing 114 in any desired location. Alternatively, or in addition, the pin connection 134 and the pin housing 114 may be configured to form a unitary structure (e.g., without a need for creating separate connections between the pin connection 134 and the pin housing 114).

The pin connection 134 may be configured to include a chip connection portion 202 that may be appropriately sized for coupling to the chip 124. For example, the pin connection 134 may be configured to have a chip connection portion 202 that may be used for conductively coupling to a top surface of the chip 124. The layer 102 may be disposed on top of the chip connection portion 202 (as shown in FIGS. la-c). The conductive coupling between the chip connection portion 202 and the chip 124 may be accomplished using soldering and/or any other desired methods.

The chip connection portion 202 may be configured to have a surface area that may be smaller than the surface area of the semiconductor chip 124. In some exemplary implementations, the chip connection portion 202 may be configured to be conductively coupled to the top working area of the chip 124.

Similarly, the pin housing 116 may be configured to include a single conductive pin connection 136. The pin connection 136 may be configured to be conductively coupled to a bottom portion of the pin housing 116. As can be understood, the pin connection 136 may be coupled to the pin housing 116 in any desired location. Alternatively, or in addition, the pin connection 136 and the pin housing 116 may be configured to form a unitary structure.

The pin connection 136 may be configured to include a chip connection portion 206 that may be sized for coupling to the chip 122. In particular, the pin connection 136 may have a chip connection portion 206 that may be used for conductively coupling to a bottom surface of the chip 122. The layer 106 may be disposed on the bottom of the chip connection portion 206 (as shown in FIGS. la-c). The conductive coupling between the chip connection portion 206 and the chip 122 may be accomplished using soldering and/or any other desired methods.

The chip connection portion 206 may be configured to have a surface area that may be smaller than the surface area of the chip 122. The chip connection portion 206 may be configured to be conductively coupled to the bottom working area of the chip 122.

In some implementations, the use of the pin connections 126 and 128 provides for connections of the chips 122, 124 to a common terminal (e.g., pin housing 112) and use of pin connections 134 and 136 provides for connections of the chips 122, 124 to separate terminals (e.g., pin housings 114, 116). Such structural connections enable the device 100 to be a multi-channel (e.g., 2-channel) protection device, which enhances its impulse surge protection, as stated above.

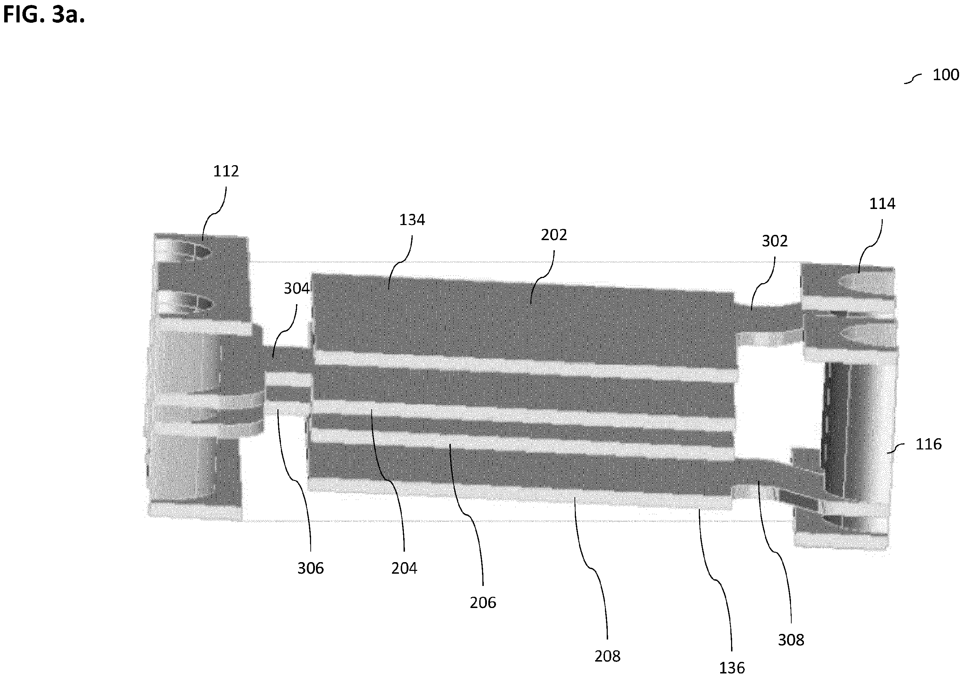

FIGS. 3a-c illustrate further details of the interior structure of the device 100 shown in FIGS. 1a-c. In particular, FIGS. 3a-c illustrate the device 100 with the layers 102-110, layers 118-120 and chips 122, 124 removed. FIG. 3a is a top perspective view of the device 100 and FIGS. 3b-c are bottom perspective views of the device 100.

As shown in FIGS. 3a-c, the chip connection portions may be configured to be connected to the respective pin housings using corresponding pin connection arms. In particular, the chip connection portion 202 may be configured to be connected to the pin housing 114 using pin connection arm 302. The chip connection portion 204 may be configured to be connected to the pin housing 112 using pin connection arm 304. The chip connection portion 206 may be configured to be connected to the pin housing 112 using pin connection arm 306. The chip connection portion 208 may be configured to be connected to the pin housing 116 using pin connection arm 308.

The arms 302-308 may be configured to extend from the respective portions 202-208 toward corresponding pin housings 112-116. For creation of separate channels between pin housings and the chips, the arms 302-308 (as well as portions 202-208) may be configured to be substantially parallel to one another and not intersect one another. This may allow for creation of separate electrical connections or channels between pin housings and the semiconductor chips. For example, one channel may constitute the pin housing 114, arm 302, portion 202, chip 124, portion 204, arm 304, and pin housing 112. Another channel may constitute the pin housing 116, arm 308, portion 208, chip 122, portion 206, arm 306, and pin housing 112. As can be understood, multiple channels may be created within a single device 100 (e.g., by having multiple semiconductor chips, multiple pin housings on one side of the device and a single pin housing on the other side of the device; and/or multiple semiconductor chips, multiple pin housings on one side of the device and multiple pin housings on the other side of the device; and/or any other variations).

In some implementations, the pin housings, pin connection arms, and pin connection portions may be manufactured from unitary conductive materials, such as, for example, zinc, copper, silver, aluminum, metals, alloys thereof, and/or any combinations thereof. Moreover, in some exemplary, non-limiting implementations, the device 100 may be configured to provide an enhanced power density of a protection device through supporting two semiconductor devices, thereby allowing flexibility of having different product combinations housed in the same package and allow a two-channel design for the chips. The device 100 may feature two or more pin connections and/or leads. Semiconductor device combinations such as TVS + TVS, TVS + triac, TVS + thyristor, TVS + diode, may be possible using the device 100.

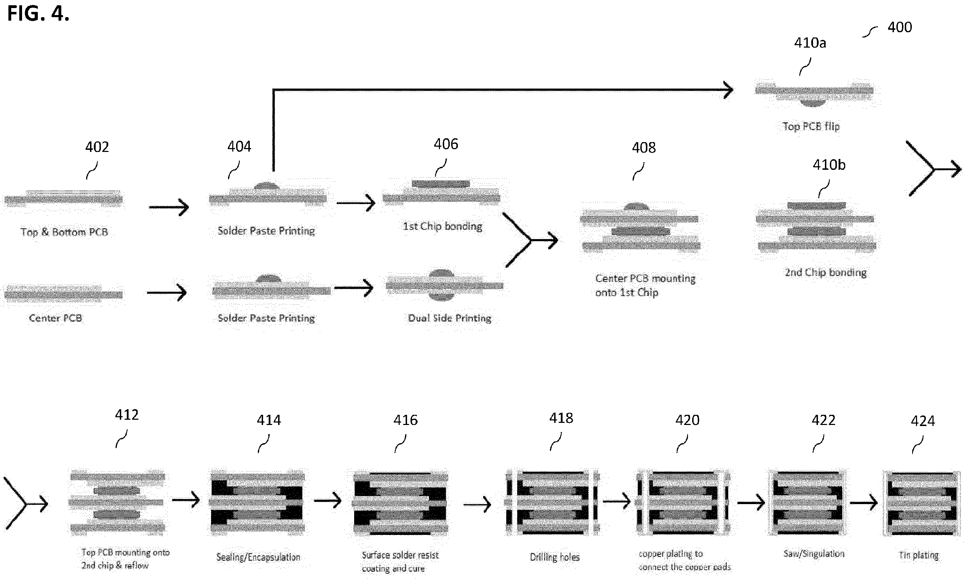

FIG. 4 illustrates an exemplary process 400 for manufacturing and/or manufacturing a multiple channel protection device, according to some implementations of the current subject matter. For example, the multiple-channel protection device may be used for packaging one or more semiconductor chip, such as, for example, a TVS device. The process 400 may be used for manufacturing and/or assembling the device 100 shown and discussed above in connection with FIGS. 1-3c.

At 402, one or more substrate and/or PCB layers may be provided. For example, the top substrate/PCB layer 102 and the bottom substrate/PCB layer 106 as well as middle/center substrate/PCB layer 104 may be provided. The top, middle, and bottom substrate layers may be formed between a first lead and a second lead), and between the first lead and the third lead (as shown in FIGS. 1a-3c. The substrate/PCB layers may be already bound to the respective chip connection portions. For example, the substate/PCB layer 102 may be already bound (on one side) to the chip connection portion 202. The substrate/PCB layer 106 may be already bound (on one side) to the chip connection portion 208. The middle/center substrate/PCB layer 104 may be bound (on each side) to respective chip connection portions 204 and 206 (as shown in FIG. 2a).

At 404, a solder paste and/or any other coupling/binding substance may be applied to and/or printed on the respective chip connection portions. For example, the solder paste may be applied to the top of the chip connection portions 202-208.

At 406, a first semiconductor chip may be provided. For example, the semiconductor chips may be a power semiconductor chip, e.g., rated for 5000 W and/or greater, and/or any other type of chips. The semiconductor chips may have any desired shape, e.g., a rectangular, non-square shape, square shape, etc. For example, the first chip 124 may be provided, then positioned on and bound to the top of the chip connection portion 208 using the applied solder paste. Solder paste may also be applied to both sides of the middle/center substrate/PCB chip connection portions 204, 206.

At 408, the middle/center substrate/PCB chip connection portions 204, 206 may be bound to the top of the semiconductor chip 124.

At 410a, the top substrate/PCB layer (coupled to the chip connection portion 202) may be re-oriented for coupling to the chip connection portion 204 (bound to the center/middle substrate/PCB layer). At 410b, a second semiconductor chip may be provided. For example, the second chip 122 may be provided, then positioned on and bound to the top of the chip connection portion 204 (bound to the center/middle substrate/PCB layer) using the applied solder paste.

At 412, the top substrate/PCB layer may be coupled to the top of the semiconductor chip 122 using solder paste.

At 414, one or more fill layers may be formed to encapsulate the semiconductor chips and the chip connection portions. At 416, solder resist coating layers (e.g., layers may be applied to the top and bottom substrate/PCB layers 102, 106 (layers 108, 110, respectively, as shown in FIG. 1a). At 418, through openings/holes in the created in the pin housings 112, 114, 116 (and/or any of the substrate/PCB layers and/or solder resist layers 108, 110, etc.). At 420, copper plating may be applied to connect to the chip connection portions. At 422 and 424, sawing and/or singulation as well as tin (and/or any other material) plating may be applied to the device.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

Some embodiments may be described using the expression "one embodiment" or "an embodiment" along with their derivatives. These terms mean that a particular feature, structure, or characteristic described in connection with the embodiment is included in at least one embodiment. The appearances of the phrase "in one embodiment" (or derivatives thereof) in various places in the specification are not necessarily all referring to the same embodiment. Moreover, unless otherwise noted the features described above are recognized to be usable together in any combination. Thus, any features discussed separately may be employed in combination with each other unless it is noted that the features are incompatible with each other.

It is emphasized that the abstract of the disclosure is provided to allow a reader to quickly ascertain the nature of the technical disclosure. It is submitted with the understanding that it will not be used to interpret or limit the scope or meaning of the claims. In addition, in the foregoing detailed description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the detailed description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects. Further, the use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the spirit and scope of the appended claims.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

The present disclosure is not to be limited in scope by the specific implementations described herein. Indeed, other various implementations of and modifications to the present disclosure, in addition to those described herein, will be apparent to those of ordinary skill in the art from the foregoing description and accompanying drawings. Thus, such other implementations and modifications are intended to fall within the scope of the present disclosure. Furthermore, the present disclosure has been described herein in the context of a particular implementation in a particular environment for a particular purpose. Those of ordinary skill in the art will recognize the usefulness is not limited thereto and the present disclosure may be beneficially implemented in any number of environments for any number of purposes. Thus, the claims set forth below are to be construed in view of the full breadth and spirit of the present disclosure as described herein.

## Claims

1. An apparatus, comprising:
a first lead having a first chip attachment portion and a second chip attachment portion;
a second lead having a third chip attachment portion;
a third lead having a fourth chip attachment portion; and
wherein a first semiconductor chip is configured to be conductively coupled to the first chip attachment portion and the third chip attachment portion, and a second semiconductor chip is configured to be conductively coupled to the second chip attachment portion and the fourth chip attachment portion.

2. The apparatus according to claim 1, further comprising a first substrate layer positioned over the third chip attachment portion and the first semiconductor chip.

3. The apparatus according to claim 2, further comprising a second substrate layer sandwiched between the first chip attachment portion and the second chip attachment portion.

4. The apparatus according to claim 3, further comprising a third substrate layer positioned over the fourth chip attachment portion and the second semiconductor chip.

5. The apparatus according to any of the preceding claims, wherein the second lead is conductively separate from the third lead.

6. The apparatus according to any of the preceding claims, further comprising a first conductive channel conductively coupling the first lead, the first chip attachment portion, the first semiconductor chip, the third chip attachment portion, and the second lead.

7. The apparatus according to claim 6, further comprising a second conductive channel conductively coupling the first lead, the second chip attachment portion, the second semiconductor chip, the fourth chip attachment portion, and the third lead.

8. The apparatus according to any of the preceding claims, wherein at least one of the first lead, the first chip attachment portion, the second chip attachment portion, the second lead, the third chip attachment portion, the third lead, and the fourth chip attachment portion include at least one of the following: zinc, copper, silver, aluminum, metals, alloys thereof, and/or any combinations thereof.

9. The apparatus according to any of the preceding claims, wherein at least one of the first and second semiconductor chips include one or more respective working areas, wherein at least one of the first, second, third, and fourth chip attachment portions are configured to be conductively coupled to the one or more respective working areas of corresponding first and second semiconductor chips.

10. The apparatus according to any of the preceding claims, wherein at least one of the first, second and third leads are configured to be coupled to at least one of the following: a substrate, a printed circuit board, and any combination thereof.

11. The apparatus according to any of the preceding claims, wherein a first fill layer is configured to be formed for encapsulating the first semiconductor chip, the first chip attachment portion and the third chip attachment portion, preferably wherein a second fill layer is configured to be formed for encapsulating the second semiconductor chip, the second chip attachment portion and the fourth chip attachment portion, more preferably wherein at least one of the first and second fill layers are manufactured from at least one of the following: an epoxy compound, a plastic, and any combination thereof.

12. The apparatus according to any of the preceding claims, wherein the apparatus is configured to be a surface mounted apparatus.

13. The apparatus according to any of the preceding claims, wherein at least one of the first and second semiconductor chips include at least one transient voltage suppression device.

14. A multiple-channel protection device, comprising:
a first lead having a first chip attachment portion and a second chip attachment portion;
a second lead having a third chip attachment portion;
a third lead having a fourth chip attachment portion; and
wherein a first semiconductor chip is configured to be conductively coupled to the first chip attachment portion and the third chip attachment portion, and a second semiconductor chip is configured to be conductively coupled to the second chip attachment portion and the fourth chip attachment portion.

15. A method, comprising:
providing one or more substrate layers, the one or more substrate layers being coupled to one or more chip connection portions;
providing one or more semiconductor chips;
coupling at least one of the one or more semiconductor chips to at least one of the one or more chip connection portions;
forming one or more fill layers to encapsulate the coupled at least one of the one or more semiconductor chips and at least one of the one or more chip connection portions;
applying one or more coating layers to at least one of the one or more formed fill layers; and
forming one or more leads in the encapsulated at least one of the one or more semiconductor chips and at least one of the one or more chip connection portions, the one or more leads being connected to at least one of the one or more chip connection portions.
